# EUROPÄISCHE PATENTSCHRIFT

(11) **EP 0 850 358 B1**
(45) Veröffentlichungstag und Bekanntmachung des Hinweises auf die Patenterteilung: **13.10.2004**
(21) Anmeldenummer: 96920714.1
(22) Anmeldetag: 27.06.1996
(51) Int. Cl.: F02P 3/055, F02P 3/04, F02P 9/00, H03K 17/615, H03K 17/042

(54) **ZÜNDENDSTUFE**
FINAL IGNITION STAGE
ETAGE DE SORTIE D'ALLUMAGE

(30) Priorität: 12.09.1995 DE 19533637
(43) Veröffentlichungstag der Anmeldung: 01.07.1998
(73) Patentinhaber: ROBERT BOSCH GMBH, 70442 Stuttgart (DE)
(72) Erfinder: MEINDERS, Horst, D-72762 Reutlingen (DE); SCHLEUPEN, Richard, D-74379 Ingersheim (DE)
(86) Internationale Anmeldenummer: PCT/DE1996/001140
(87) Internationale Veröffentlichungsnummer: WO 1997/010432

(56) Entgegenhaltungen:
- EP-A- 0 602 978
- EP-A- 0 727 578
- WO-A-90/05848
- WO-A-92/05364
- WO-A-92/10673
- DE-A- 2 703 120
- DE-A- 3 334 833
- DE-A- 3 723 581
- DE-A- 4 009 304

## Beschreibung

### Stand der Technik

Die Erfindung betrifft eine Zündendstufe für eine Brennkraftmaschine. Aus der DE-OS 23 39 896 ist eine Zündendstufe für Brennkraftmaschinen bekannt, bei der die Primärwicklung der Zündspule mit der Schaltstrecke eines Schalttransistors in Reihe geschaltet ist. Der Schalttransistor ist als Darlington-Schaltung realisiert, wobei parallel zur Kollektor-Basisstrecke eine Zenerdiode geschaltet ist. Diese Zenerdiode sorgt dafür, daß die Spannung an der Schaltstrecke des Schalttransistors einen zulässigen Wert nicht übersteigt. Hohe Spannungen, die eine Gefahr für den Schalttransistor darstellen, treten insbesondere beim Übergang der Schaltstrecke des Schalttransistors in den nichtleitenden Zustand auf und werden durch die auf die Primärseite transformierte Hochspannung erzeugt.

Erreicht die Kollektor-Emitter-Spannung die Zenerspannung der Basis-Kollektor-Diode, so fließt ein Zenerstrom in die Basis des Zünddarlington. Dieser wird hierdurch wieder leitend geschaltet, so daß im Klammerbetrieb gleichzeitig eine Spannung anliegt und Strom fließt, bis der Zündfunke auf der Sekundärseite der Spule überspringt und die restliche Spulenenergie in die Funkenstrecke fließt.

Die Zündspule einer Zündschaltung ist bei rotierender Verteilung über einen Zündverteiler oder bei ruhender Verteilung direkt mit der entsprechenden Zündkerze des Verbrennungsmotors verbunden. Dabei können sehr große Kabellängen zwischen den einzelnen Anschlüssen z.B. zwischen dem Schalttransistor und der Zündspule und zwischen dem Schalttransistor und Masse und zwischen dem Ansteuerschaltkreis des Zünddarlington und der Basis des Zünddarlington auftreten. Die aufgrund der elektrischen Kabel vorhandenen ohmschen Widerstände und Induktivitäten besitzen eine Antennenwirkung, so daß beim Zündvorgang die Basisleitung des Schalttransistors schwach mit parasitärem Basisstrom versorgt wird, was dazu führt, daß die Zündspannung nur langsam den vollen zum Zünden notwendigen Wert erreicht, da der Schaltransistor durch diesen parasitären Strom wieder etwas aufgesteuert wird. Diesem Effekt kann durch die Realisierung möglichst kurzer Emitter- und Kollektorleitungen oder durch die Verwendung abgeschirmter Ansteuerleitungen für die Basis des Schalttransistors Rechnung getragen werden.

Eine Zündendstufe gemäß Oberbegriff des vorliegenden Hauptanspruchs ist aus der DE-A-2 703 120 bekannt.

### Vorteile der Erfindung

Die Erfindung gemäß dem vorliegenden Hauptanspruch hat gegenüber dem Bekannten den Vorteil, daß eine einfache, kostengünstige und sehr wirksame Absicherung der Basisleitung des Schalttransisors vor parasitären Einwirkungen gegeben ist. Des weiteren ist diese Schaltung sehr gut monolithisch integrierbar.

### Ausführungsbeispiele

Ausführungsbeispiele der Erfindung sind in den Figuren dargestellt. Es zeigen
Figur 1 eine Zündendstufe mit interner einstufiger Klammerung und einem Kurzschlußtransistor
Figur 2 eine zweite Zündendstufe mit externer, mehrstufiger Klammerung und Kurzschlußtransistor,
Figur 3 ein erstes Ausführungsbeispiel einer Zündendstufe mit interner einstufiger Klammerung und mit Kurzschlußtransistor,
Figur 4 den Verlauf der Klammerspannung ohne Kurzschlußtransistor,
Figur 5 den Verlauf der Klammerspannung mit Kurzschlußtransistor,
Figur 6 Kurzschlußtransistor in den Zünddarlington monolithisch integriert.

### Beschreibung der Ausführungsbeispiele

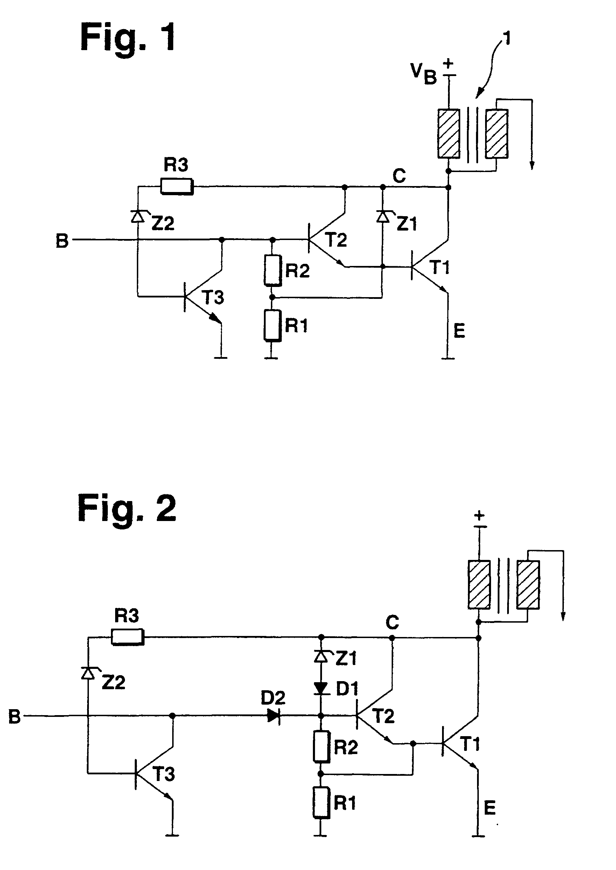

Figur 1 zeigt ein Prinzipschaltbild einer Zündendstufe mit einer internen, einstufigen Zenerklammerung, wie sie in Zündanlagen für Brennkraftmaschinen eingesetzt werden. Die Schaltung in Figur 1 besteht aus einer Zündspule 1, die sekundärseitig mit einer nicht dargestellten Zündkerze verbunden ist. Die Primärwicklung der Zündspule 1 ist einerseits mit der Versorgungsspannung U_{B} beispielsweise der nicht dargestellten Batterie des Fahrzeugs und andererseits über einen Leistungstransistor T1 mit Masse verbunden. Dem Leistungstransistor T1 ist ein Treibertransistor T2 derart vorgeschaltet, daß ein zweistufiger Darlington-Transistor entsteht. Die Kollektor-Emitter-Strecke des Leistungstransistors T1 liegt mit der Primärwicklung in Reihe, und die Basis des Leistungstransistors T1 ist mit dem Emitter des Treibertransistors T2 verbunden. Dem Leistungstransistor T1 und der Treiberstufe T2 sind jeweils die Basis-Emitter-Widerstände R1 bzw. R2 zugeordnet.

Parallel zur Kollektor-Basisstrecke des Leistungstransistors T1 ist eine Zenerdiode Z1 vorgesehen. Diese Zenerdiode Z1 dient dazu, dem Leistungstransistor T1 vor Überspannung zu schützen, wenn er beim Abschaltens des Ladestromes in der Zündspule eine Hochspannung induziert. Dies geschieht, indem der Zenerdiodendurchbruchstrom in die Basis des Leistungstransistors T1 fließt und der Darlington wieder voll aufgesteuert wird. Diese Anordnung der Zenerdiode Z1 parallel zur Kollektor-Basis-Strecke des Leistungstransistors T1 innerhalb des Darlingen-Transistor ist eine interne, einstufige Klammerung. Diese Anordung ist jedoch bereits bekannt. Ein wesentliches Merkmal besteht in der Anordnung eines Kurzschlußtransistors T3, wobei die Kollektor-Emitter-Strecke des Kurzschlußtransistors T3 parallel zur Basis-Emitter-Strecke des Darlington-Transistors geschaltet ist, d.h. der Kollektor des Kurzschlußtransistors ist mit dem Basisanschluß des Treibertransistors T2 und der Emitter des Kurzschlußtransistors T3 ist über die Masse mit dem Emitter des Treibertransistors T2 verbunden. In der Verbindung vom Kollektor des Treibertransistors T2 des Darlington-Transistors zur Basis des Kurzschlußtransistors T3 befindet sich ein Widerstand R3 und eine zweite Zenerdiode Z2. Die zweite Zenerdiode Z2 verhindert, daß der Kurzschlußtransistor T3 bereits während der Ladephase der Zündspule, wenn das Potential des Darlington-Kollektors in die Nähe der Betriebsspannung kommt, aufgesteuert wird. Der Widerstand R3 wird dabei so festgelegt, daß bei einer Klammerspannungen von 300 bis 400 V der Zenerdiode Z1 ein ausreichender Basisstrom für den Kurzschlußtransistor T3 fließen kann.

Ein weiteres Beispiel ist in Figur 2 gezeigt. Die Anordnung des Darlingtou-Transistors und der Zündspule entspricht der Anordnung in Figur 1 und gleiche Bauteile sind mit dem gleichen Bezugszeichen versehen. Im Unterschied zu Figur 1 hat diese Zündanlage eine externe, mehrstufige Klammerung, d.h. die Zenerdiode Z1 für die Klammerung ist parallel zur Kollektor-Emitter-Strecke des Treibertransistors T2 also außerhalb des zweistufigen Darlington-Transistors angeordnet. Des weiteren ist in Reihe mit der ersten Zenerdiode Z1 zwischen Zenerdiode Z1 und Basisanschluß des Treibertransistors T1 eine Diode D1 angeordnet. Diese Diode D1 dient zur Entkopplung der Basis des Treibertransistors vom Darlington-Kollektor. Vom Abgriff zwischen Primärwicklung und Kollektor des Steuertransistors, welches ja gleichzeitig den Kollektor des Darlington bildet, ist der Klammerzweig bestehend aus Zenerdiode Z1 und Diode D1 an den Ansteueranschluß des Darlington also an die Basis des Treibertransistors T2 geführt. Außerdem ist dieser Abgriff am Verbindungspunkt zwischen Primärwicklung und Kollektor des Darlington ebenfalls wie in Figur 1 über den Schutzwiderstand R3 und die zweite Zenerdiode Z2 mit der Basis des Kurzschlußtransistor T3 verbunden. Ihre Wirkungsweise wurde bereits zu Figur 1 erläutert. In dieser Figur 2 ist im Unterschied zu Figur 1 zwischen dem Kollektor des Kurzschlußtransistors T3 und dem Ansteueranschluß des Darlington eine zweite Diode D2 angeordnet, welche den Klammerkreis entkoppelt, so daß über den Klammerkreis nur der zum Aufrechterhalten des jeweils fließenden Kollektorstromes benötigte Basisstrom fließt. Jeder parasitäre einströmende Basisstrom wird hier kurzgeschlossen.

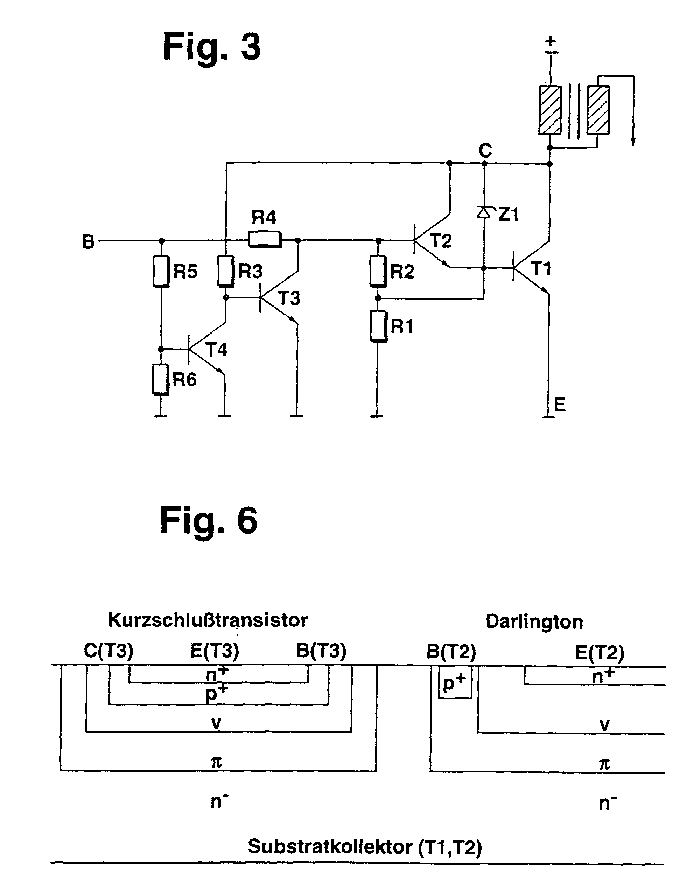

Figur 3 zeigt ein Ausführungsbeispiel der erfindungsgemäßen Kurzschlußschaltung. Wie in Figur 1 erfolgt auch bei dieser Anordnung die Ansteuerung des Ladestroms durch die Zündspule über einen zweistufigen Darlington-Transistor. Die Spannungsklammerung zum Schutz vor Überspannungen ist als einstufige interne Klammerung realisiert, die bereits zu Figur 1 erläutert wurde. Im Unterschied zu Figur 1 hat der Darlington einen Basiseingangswiderstand R4, welcher dafür sorgt, daß sich der Darlington vom stromlosen in den angesteuerten Betrieb einschalten läßt. Zwischen dem Basiseingangswiderstand R4 und dem Ansteueranschluß des Darlington ist der Kollektor des Kurzschlußtransistors T3 angeschlossen. Die Basis des Kurzschlußtransistors T3 ist wie in Figur 1 über einen Schutzwiderstand R3 mit dem Kollektor des Darlington verbunden. Parallel zum Basiseingangswiderstand R4 ist nach Masse ein Spannungsteiler aus den Widerständen R5 und R6 angeordnet, wobei der Abgriff des Spannungsteilers mit der Basis eines vierten Transistors T4 kontaktiert ist. Der Kollektor des vierten Transistors T4 ist an die Verbindung zwischen Schutzwiderstand R3 und Basis des Kurzschlußtransistors T3 geführt. Damit wird der Ansteuerstrom für den Kurzschlußtransistor T3 aus dem invertierten Ansteuersignal für die Basis des Darlington gewonnen. Liegt ein Ansteuersignal an der Basis des Darlington an, dann ist der Kollektor des vierten Transistors auf Massepotential und der Kurzschlußtransistor T3 bleibt stromlos. Bei fehlendem Ansteuersignal an der Basis des Darlington ist T4 stromlos und der Kurzschlußtransistor T3 wird über den hochohmigen Schutzwiderstand R3 mit Basisstrom versorgt und schließt die Basis-Emitter-Strecke des Darlington kurz. Bei dieser Verschaltung kann die dem Kurzschlußtransistor vorgeschaltete Zenerdiode entfallen. Der Basiseingangswiderstand R4 ermöglicht den Übergang vom stromlosen Darlington-Betrieb (Kurzschlußtransistor T3 aktiv) in den angesteuerten Betrieb (Kurzschlußtransistor T3 offen). Der Spannungsteiler R5/R6 verhindert, daß Ansteuerstrom am Transistor 4 verloren geht. Gleichzeitig sorgt dieser Spannungteiler dafür, daß unabhängig von der Spannung der Basis-Emitter-Strecke die Einschaltschwelle des Transistors T1 erreicht wird. Diese Schaltung gemäß Figur 3 hat den Vorteil, daß im Gegensatz zu den Ausführungsbeispielen der Figuren 1 und 2 auch eine Folgefunkenzündung möglich ist, da der Kurzschlußtransistor T3 wieder ausgeschaltet wird und sich so der Darlington wieder einschalten läßt.

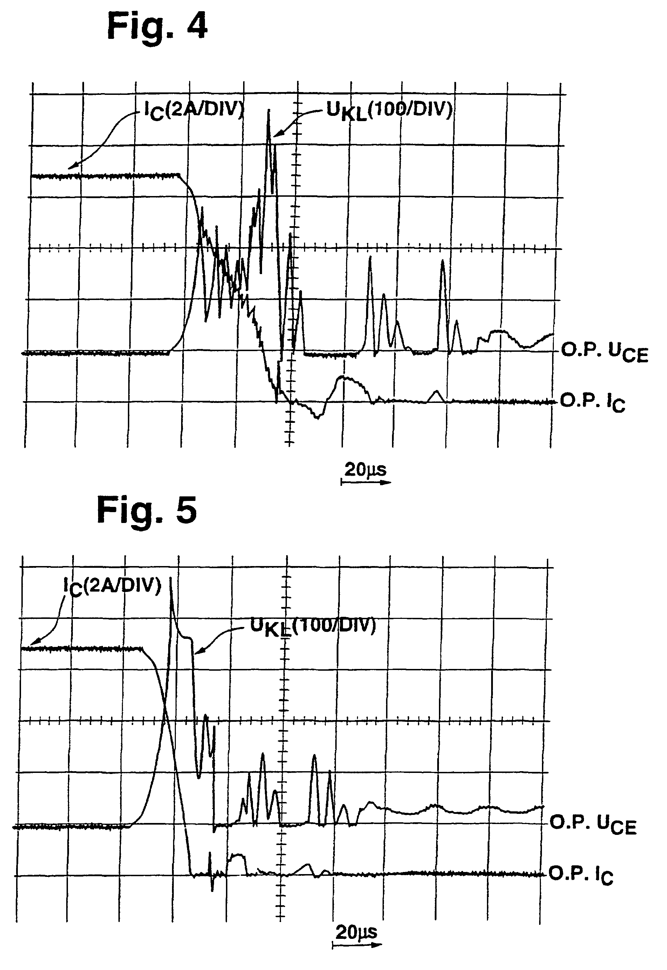

Die Funktionsweise der beschriebenen Beispiele soll anhand der Figuren 4 und 5 nochmals erläutert werden. Hier sind die Spannungsverläufe einmal ohne Kurzschlußtransistor (Figur 4) und einmal mit Kurzschlußtransistor (Figur 5) dargestellt. Bei der untersuchten Zündschaltung handelt es sich um einen dreistufigen Darlington mit interner Klammerung direkt auf den Ansteuertransistor T1, während der Kurzschlußtransistor T3 auf die dritte Basis des Darlington-Transistors wirkt. Die Klammerung erreicht ohne den Kurzschlußtransistor T3 erst nach ca. 30 µs begleitet von mehreren Spannungseinbrüchen ihren vollen Wert, der Kollektorstrom klingt entsprechend den mehrfachen Wiedereinschalteffekten nur langsam und keineswegs linear ab. Die Spannung in einer Zündschaltung mit dem Kurzschlußtransistor T3 wird schon nach 20 µs erreicht. Der Überschwinger hängt mit dem speziellen Klammersystem zusammen, bei dem kapazitive und ohmsche Teiler nicht genau abgestimmt sind. Durch diese Verbesserung des Abschaltvorgangs und die Unterdrückung des parasitären Wiedereinschaltens von Klammern ist diese Schaltung für alle Zündanwendungen einsetzbar.

Häufig gibt es auch Zündanlagen, bei denen der Zünddarlington extern über den äußeren Basisanschluß gezenert wird. In diesem Fall muß der Kurzschlußtransistor wie in Figur 2 angegeben verschaltet werden.

Es ist bereits aus den Steuergeräten bekannt, daß der Zünddarlington als integrierte Schaltung aufgebaut werden kann. Aber auch der Kurzschlußtransistor läßt sich hier gut in diese Schaltung monolithisch integrieren.

Die Realisierung des Kurzschlußtransistors T3 in integrierter Bauweise erfolgt mittels Isolationsdiffusion, damit der Kollektor des Kurzschlußtransistor T3 von dem Kollektor des Darlington getrennt ist. Bei diesen Isolationsdiffusionen müssen die n⁺- und p⁺-Wannen in weitere γ- und π-Wannen eingebettet werden, wie in Figur 6 dargestellt. Durch diese hochohmigen γ- und π-Diffusionen lassen sich Basis und Kollektor des Kurzschließers effektiv gegen den Substratkollektor isolieren. Die Sperrfähigkeit der Kollektorbasisstrecke von T3 muß nicht unbedingt der Klammerspannung entsprechen, weil am vorgeschalteten Widerstand R3 der Hauptteil der Klammerspannung abfällt.

In der gleichen Weise läßt sich eine Integration der Zenerdiode durch eine p -Zone, eingebettet in 2 γ/π-Wannen realisieren mit Sperrspannungen von 20-50 V. Die Zenerdiode ist ebenfalls wieder über die π-Diffusion vom Substratkollektor isoliert wird.

Die Integration des Schutzwiderstandes R3 ist relativ flächenaufwendig, so daß man die bereits vorhandenen Deckelelektrodenteilwiderstände gleichzeitig auch als Ansteuerwiderstand für den Kurzschlußtransistor T3 verwenden kann. So tritt bei einer Deckelelektrodenklammerung kein zusätzlicher Flächenbedarf für den Ansteuerwiderstand auf.

## Patentansprüche

1. Zündendstufe für Brennkraftmaschinen mit einem Darlington-Transistor, mit einem Treibertransistor (T2) und einem Steuertransistor (T1), wobei parallel zur Basis-Emitter-Strecke des Darlington-Transistors die Kollektor-Emitter-Strecke eines Kurzschlußtransistors (T3) liegt, wobei der Darlington-Transistor eine Klammerung mittels Zenerdiode (Z1) aufweist und wobei der Steueranschluß des Kurzschlußtransistors über einen hochohmigen Schutzwiderstand (R3) mit dem Kollektor des Darlington-Transistors verbunden ist und wobei der Schutzwiderstand (R3) so dimensioniert ist, daß ein ausreichender Basisstrom für den Kurzschluß-Transistor (T3) fließt, **dadurch gekennzeichnet, daß** zwischen dem hochohmigen Widerstand (R3) und dem Ansteueranschluß des Kurzschluß-Transistors (T3) der Kollektor eines vierten Transistors (T4) angeschlossen ist und die Basis des vierten Transistors (T4) über einen Spannungsteiler (R5, R6) mit dem Ansteueranschluß des Darlington-Transistors verbunden und der Emitter des vierten Transistors gegen Masse geschaltet ist.

2. Zündendstufe nach Anspruch 1, **dadurch gekennzeichnet, daß** zwischen dem Kollektor des Kurzschluß-Transistors (T3) und dem Ansteueranschluß des Darlington-Transistors eine Entkoppeldiode (D2) geschaltet ist.

3. Zündendstufe nach Anspruch 1 oder 2, **dadurch gekennzeichnet, daß** der Darlington-Transistor eine einstufige interne Klammerung mittels Zenerdiode (Z1), die parallel zur Kollektor-Emitterstrecke des Treibertransistors (T2) des Darlington-Transistors geschaltet ist, aufweist.

4. Zündendstufe nach einem der vorhergehenden Ansprüche, **dadurch gekennzeichnet, daß** alle Komponenten wie Zenerdiode, Kurzschlußtransistor, hochohmiger Widerstand (R3) und vierter Transistor (T4) monolithisch integriert sind.

## Claims

1. Ignition output stage for internal combustion engines having a Darlington transistor, having a driver transistor (T2) and a control transistor (T1), the collector-emitter path of a short-circuit transistor (T3) being connected in parallel with the base-emitter path of the Darlington transistor, the Darlington transistor having a clamped connection by means of a Zener diode (Z1) and the control terminal of the short-circuit transistor being connected to the collector of the Darlington transistor via a high-impedance protective resistor (R3) and the protective resistor (R3) being dimensioned in such a way that a sufficient base current for the short-circuit transistor (T3) flows, **characterized in that** the collector of a fourth transistor (T4) is connected between the high-impedance resistor (R3) and the drive terminal of the short-circuit transistor (T3), and the base of the fourth transistor (T4) is connected to the drive terminal of the Darlington transistor via a voltage divider (R5, R6), and the emitter of the fourth transistor is connected to earth.

2. Ignition output stage according to Claim 1, **characterized in that** a decoupling diode (D2) is connected between the collector of the short-circuit transistor (T3) and the drive terminal of the Darlington transistor.

3. Ignition output stage according to Claim 1 or 2, **characterized in that** the Darlington transistor has a single-stage internal clamped connection by means of a Zener diode (Z1) which is connected in parallel with the collector-emitter path of the driver transistor (T2) of the Darlington transistor.

4. Ignition output stage according to one of the preceding claims, **characterized in that** all the components such as Zener diode, short-circuit transistor, high-impedance resistor (R3) and fourth transistor (T4) are monolithically integrated.

## Revendications

1. Etage de sortie d'allumage pour des moteurs à combustion interne comprenant un transistor de Darlington avec un transistor d'attaque (T2) et un transistor de commande (T1), le trajet collecteur-émetteur d'un transistor en court-circuit (T3) s'étendant parallèlement au trajet base-émetteur du transistor de Darlington, le transistor de Darlington présentant une connexion au moyen d'une diode de Zener (Z1) et le raccord de commande du transistor en court-circuit étant relié au collecteur du transistor de Darlington par l'intermédiaire d'une résistance protectrice (R3) de valeur ohmique élevée, et la résistance protectrice (R3) étant dimensionnée pour assurer une circulation de courant de base suffisante pour le transistor en court-circuit (T3).
**caractérisé en ce que**
le collecteur d'un quatrième transistor (T4) est raccordé entre la résistance (R3) de valeur ohmique élevée et le raccord de commande du transistor en court-circuit (T3), et la base du quatrième transistor (T4) est reliée au raccord de commande du transistor de Darlington par l'intermédiaire d'un diviseur de tension (R5, R6) et l'émetteur du quatrième transistor est mis à la masse.

2. Etage de sortie d'allumage selon la revendication 1,
**caractérisé en ce qu'**
une diode de découplage (D2) est montée entre le collecteur du transistor en court-circuit (T3) et le raccord de commande du transistor de Darlington.

3. Etage de sortie d'allumage selon la revendication 1 ou 2,
**caractérisé en ce que**
le transistor de Darlington présente une connexion intérieure à un étage au moyen d'une diode de Zener (Z1) montée parallèlement au trajet collecteur-émetteur du transistor d'attaque (T2) du transistor de Darlington.

4. Etage de sortie d'allumage selon l'une quelconque des revendications précédentes,
**caractérisé en ce que**
tous les composants comme la diode de Zener (Z1), le transistor en court-circuit (T3), la résistance protectrice de valeur ohmique élevée (R3) et le quatrième transistor (T4) sont intégrés de manière monolithique.
